(19) **Europäisches Patentamt / European Patent Office / Office européen des brevets**

(11) **EP 1 841 058 B1**

(12) # EUROPEAN PATENT SPECIFICATION

(45) Date of publication and mention
of the grant of the patent:
**06.07.2011 Bulletin 2011/27**

(51) Int Cl.:
***H03C 1/60*** (2006.01)

(21) Application number: **06425224.0**

(22) Date of filing: **31.03.2006**

(54) **Method and system to improve local oscillator signal rejection in single-sideband radiofrequency up-converters**

Sender mit unterdrücktem Träger,und Verfahren dazu

Emétteur avec porteuse supprimée , et procédé

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**03.10.2007 Bulletin 2007/40**

(73) Proprietor: **Nokia Siemens Networks S.p.A.**
**20060 Cassina de'Pecchi (MI) (IT)**

(72) Inventors:
• **Montiron, Giuseppe**
**27058 Voghera (PV) (IT)**
• **Negri, Luigi**
**26866 Sant Angelo Lodigiano (IT)**
• **Piloni, Marco**
**20090 Vimodrone (MI) (IT)**

(74) Representative: **Fischer, Michael et al**
**Nokia Siemens Networks GmbH & Co. KG**
**COO RTP IPR, Patent Administration**
**80240 München (DE)**

(56) References cited:
| | |
|---|---|
| EP-A- 0 661 801 | US-A- 5 162 763 |
| US-A- 5 343 171 | US-A- 5 903 823 |
| US-B1- 6 169 463 | US-B1- 6 720 839 |

EP 1 841 058 B1

**EP 1 841 058 B1**

Description

**FIELD OF THE INVENTION**

The present invention relates to the field of radio transmitters, and more precisely to a method and system to improve local oscillator signal rejection in single-sideband radiofrequency up-converters.

**BACKGROUND ART**

The problem to reduce Local Oscillator (LO) residual signal at mixer up-converter RF port is one of the most critical issue to face in the design of RF module for wireless systems. Standard RF up-converters generally include mixer diodes in balanced configuration. At present, the most used techniques to improve the performance are the design of very accurate balanced mixer or the use of high Q filter at RF mixer port; anyway both these solutions can show some drawbacks such us narrow band operation, low LO suppression at high frequency and expensive circuitry. A good method to suppress the local oscillator signal completely is to improve the mixer symmetry by biasing each of the diodes or by applying a differential voltage for two diodes. But when the frequency is changed, the bias voltage has to be readjusted. Furthermore, by effect of temperature variations and aging the grade of balancing may change during the operational life of the mixing diodes and the LO rejection is no more optimal, consequently.

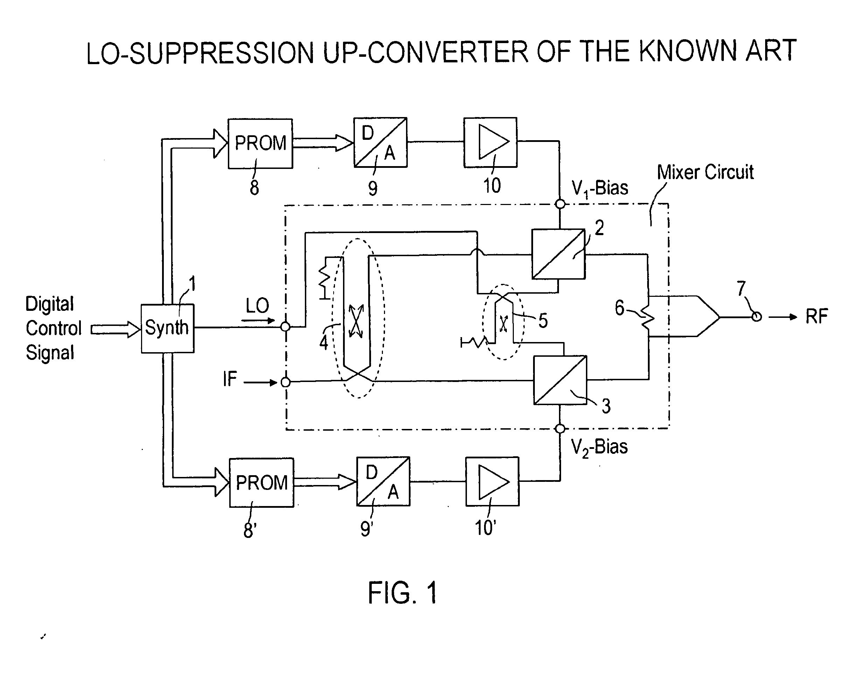

An attempt to improve the rejection of LO signal is described in the article of W. Schiller, titled: "Broadband linear SSB-upconverter with electronically-controlled LO-suppression for 16 QAM applications at 4 GHz", published on Conf. Proc. 13th European Microwave Conf., Nuernberg, D, Sep. 5-8 1983. The architecture of this LO-suppression up-converter is depicted in **fig.1.** With reference to **fig.1** we see a frequency synthesizer 1 controlled by a digital control signal to synthesize a local oscillator signal LO at a frequency beating with an Intermediate Frequency (IF) signal for obtaining a Radiofrequency (RF) signal inside the desired channel band. In order to achieve a good sideband suppression, instead of using a demanding RF filter the circuitry employs well known phasing methods to build a single-sideband frequency converter by using two identical balanced or double-balanced mixer circuits 2, 3 together with power splitter and quadrature hybrids 4 and 5. The balanced RF signal between the outputs of the two converters 2 and 3 applied to the two ends of an interposed resistor 6, is coupled to an output RF port 7. Single side-sideband does not solve the problem of poor local oscillator isolation with respect to the RF output level. To this specific aim the synthesizer 1 further outputs on two distinct buses a same digital word which is the one necessary to set the frequency of the LO. The two digital words are used to control two identical electronic circuits which can adjust the proper bias voltages of respective mixers 2 and 3 for every used frequency. These are very simple circuits consisting of a PROM 8, 8' followed by a digital-to-analog converter 9, 9' and an operational amplifier 10, 10'. If, for example, 8 bits are used, the bias voltages far up to 256 channels can be stored in a memory. When the synthesizer frequency is set, the frequency information is given to the two PROMs 8 and 8'. The output of PROM 8 feeds the digital-to-analog converter 9, the analog voltage from the conversion applied at the input of the operational amplifier 10 causes a bipolar output voltage for biasing the mixer 2. The same happens on the other branch. Polarity and value of the bias voltage is determined by said digital word. The two bias voltages are used as differential bias for each of the two balanced mixers 2 and 3; each voltage can have values between $+V_{REF}$ and in $-V_{REF}$ in 256 increments, this is sufficient far all cases. For programming the PROMS, the LO-level at the mixer output is in a first step measured and, in a second step, optimized for best suppression by adjusting the bias voltages. These voltages are evaluated for each oscillator frequency and stored in the PROM. This time-consuming procedure is simplified by the use of a computer controlled measuring system consisting of a spectrum analyzer, such as the HP 8566A, and a desktop computer. As can be directly seen on the display of HP 8566A, biasing with differential bias only affects the suppression of local oscillator; upper and suppressed lower sideband and all other higher order products remain unchanged. This can be done far every used local oscillator frequency.

Long and demanding pre-integrating calibrations are needed to achieve good LO rejection in the SSB up-converters according to the solution proposed in the article of W. Schiller. This because external sophisticated instruments such as spectrum analyzer and personal computer shall be provided. The static calibration table is substantially obtained only at the beginning of the operation, so that the side effects of different variations on physical parameters of the two mixers during lifetime, due to temperature and aging, are not immediately and easily recoverable. For example, to account for temperature variations larger and more complicated calibration tables are needed. The unique way to recover the aging is that to repeat on-site the initial sophisticated calibration procedure but some objective difficulties arise.

US-A-5162763 (Morris) discloses a single sideband modulator including means of translating low frequency baseband signals directly to radiofrequency in a single stage providing suppressed carrier. Control signals are continuously generated to keep the local oscillator breakthrough and image sideband down to an insignificantly low level. This is achieved by monitoring amplitude of the RF output of the single sideband modulator, and comparing this with the baseband signals. By adjusting the d.c. offsets at the baseband inputs to the balanced modulators carrier breakthrough is cancelled. By adjusting the relative phases of the baseband signals deviations from the 90° split are compensated.

By changing the amplitude of one of the baseband signals, the level of one of the RF paths is adjusted to achieve amplitude balance.

Diversely of the article of W. Schiller the single sideband modulator of the US-A-5162763 has dynamic behaviour in suppressing the residual carrier. Continuous updating of the degree of balance is achieved by an analog feedback control block including four mixers connected to four ower amplifiers. Due to the analog circuital approach, the exerted feedback control is rather complicated in achieving optimal rejection; this depends on the considerable number of variables to keep simultaneously under control.

## OBJECT AND SUMMARY OF THE INVENTION

Object of the present invention is to improve the LO signal rejection in image-rejection modulators wherein neither that static calibration tables are needed nor a limiting analog approach.

The invention achieves the declared object by providing a method to improve local oscillator LO signal rejection in single-sideband radiofrequency up-converters comprising a balanced or double-balanced mixer including diodes biased with adjustable currents to improve said rejection, as disclosed in claim 1.

Additional advantageous features are described in dependent claims.

The method of the invention includes the following steps:

a) driving an auxiliary mixer with the output radiofrequency RF signals for down-converting the residual power of LO signal from the beating between the two signals;

b) detecting a quasi-continuous voltage $V_{REG}$ generated by the down-converted residual power of LO signal;

c) obtaining from said voltage $V_{REG}$ two voltages Vd1 and Vd2 to continuously updating the biasing currents Id1 and Id2 of said diodes, by providing a mathematical function $V_{REG}(Id1, Id2)$ of the two bias currents Id1 and Id2 and then minimizing it through the gradient descent algorithm or through any other equivalent algorithms known in the art.

When descent gradient method is the previous step c) is completed as in the following:

d) calculating the gradient of said mathematical function $V_{REG}(Id1_k, Id2_k)$ where index k indicates the actual calculation step;

e) multiplying the gradient by a learning factor $\eta > 0$ and changing the sign of the product in order to find a vectorial variation of the bias currents for updating both $Id1_k$, $Id2_k$ and $V_{REG}(Id1_k, Id2_k)$;

f) comparing the module of said product with a predetermined target threshold $\varepsilon$ and if the module is lower than or equal to said threshold $\varepsilon$ calculating next values of the bias currents $Id1_{k+1}$, $Id2_{k+1}$ by summing up said vectorial variation of the bias currents to the actual values $Id1_k$ and $Id2_k$ and after a waiting time is expired and Vd1 and Vd2 updated, executing a new updating iteration from step d), otherwise when said module is equal to or lower than the threshold $\varepsilon$ stopping to update the bias currents and executing a new updating iteration from step d) after the waiting time is expired and Vd1 and Vd2 updated.

The function f(Id1, Id2) is either derivable by means of pure theoretical considerations or experimentally by interpolating through a grid of measures involving pairs of close bias currents Id1, Id2 and corresponding quasi-continuous voltages obtained by the LO residual power down-converted to IF. The function f(Id1, Id2) reflects the non-linear behaviour of the mixer, let us assume the shape of f(Id1, Id2) is the same for all production lot of up-converters but slightly differently offset in respect of the axes: well, the gradient equalizes the whole functions independently of their offsets, consequently it is calculated only once and stored locally.

Other object of the invention is a system to improve local oscillator signal rejection in single-sideband radiofrequency up-converter comprising a balanced or double-balanced mixer biased with differential currents and operating according to the method of above, as disclosed in a device independent claim. The mixer can be implemented using diodes or FETs, indifferently, although diodes are preferable.

The system of the invention improves the rejection of the LO signal by means of a bias calibration feedback loop for recovering possible mixer unbalances .

According to a first embodiment of the system invention, the bias calibration feedback loop is set to exploit the mixing effect of an RF detector that belongs to an automatic level control loop (ALC) acting on the RF power amplifier. Said feedback loop originates from an RF power splitter connected to an auxiliary mixer which constitutes the RF detector driven by the output RF signal power. This way, whenever RF power input to the RF detector is hold constant by ALC loop, an IF power is generated from the beating of the residual LO with the RF signal as driving power. The output level at IF follows the residual level change of LO at the input of the RF detector. The IF power originated from down conversion of residual LO is used to derive optimal bias voltage/current values across the double-balanced mixer, so as to minimize the residual power of LO. Any suitable known minimization algorithm can be used. Due to the wide dynamic range of the IF power, a cheap logarithmic amplifier further operating as level detector is provided at the input of conditioning circuitry. The latter includes a microprocessor with ADC and DACs at the input and outputs, respectively, and two operational amplifiers configured as voltage-to-current converters which pilot the double-balanced mixer with differential currents.

According to a an alternative embodiment of the system invention, the bias calibration feedback loop is made completely independent of the ALC loop. A first power splitter is used to derive the RF signal power at the output of the up-converter, opportunely amplified, towards the input of the bias calibration loop. A second power splitter is used, with or without a relaxed interstage RF filter, to derive the RF power at the output of the final RF amplifier towards the input of the ALC loop. Differently from the first embodiment, the residual power of LO down-converted to IF has low dynamic range and a simple operational amplifier instead of logarithmic is used. The steady state can be reached before switching the RF power amplifier on at power up.

## ADVANTAGES OF THE INVENTION

The one or the other embodiment of the invention allow wideband operation and improve LO rejection without needing a narrowband interstage RF filter. The first embodiment is cheaper because a mixer and a power splitter is saved, but the LO residual power converted back to IF is in minor measure affected by the indirect RTPC action on the RF detector. The second embodiment is more expensive but allows good and stable suppression because the LO residual power is independent from the RTPC action. Anyway, transient lack of LO suppression, like it can happen for example at power-up or when a large output power variation occurs, can generally be tolerated by the two embodiments because only output power precision is affected, while spurious emission limits are always guaranteed by a diplexer filter.
Being continuous feedback calibration active, no preconfigured calibration tables are needed to compensate for carrier frequency changes. Possible spread on the physical parameters of the double-balanced mixer due to the aging can be recovered without worsen the symmetry of the balanced mixer and hence the LO rejection. The same is true for possible side effects on the LO residual due to temperature variations.

## BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:

- **fig.1,** already described, shows a block diagram of a LO-suppression up-converter of the prior art;
- **fig.2** shows a block diagram of the system according to a first embodiment of the present invention;
- **fig.3a** shows the equivalent circuit of a double-balanced mixer of fig.2;
- **fig.3b** shows the bias current injection circuits for the double-balanced mixer of fig.2;
- **fig.4** shows the effective realization of a 38 GHz up-converter of fig.2;
- **fig.5** shows a block diagram of the system according to a second embodiment of the present invention;
- **fig.6** shows a flow chart of a possible autocalibration routine executed by a microcontroller of figures 2 and 5.

## DETAILED DESCRIPTION OF AN EMBODIMENT OF THE INVENTION

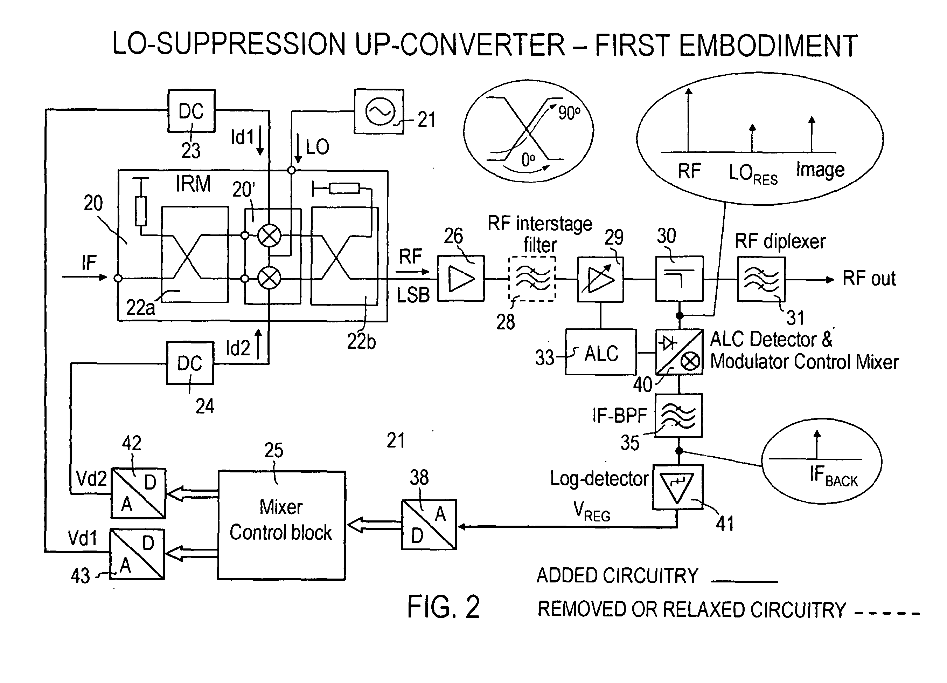

With reference to **fig.2,** we see a circuitry built up around a single-sideband frequency up-converter 20, also termed Image Rejection Mixer (IRM). The IRM block 20 is well known in the art, see for example:

- Watkins-Johnson Company - Tech-Notes, Vol. 12 No. 3, May/Jun 1985.
- Halford, B. R., "Single-Sideband Mixers for Communication Systems", 1982 IEEE MTT Symposiums Digest, pp. 30-32.

The IRM block 20 includes a double-balanced diode mixer 20' pumped by a LO sinusoidal signal generated by a local oscillator 21, a first quadrature hybrid 22a, and a second quadrature hybrid 22b. The first quadrature hybrid 22a operates as IF splitter connected to a balanced IF port of the double-balanced diode mixer 20'. The second quadrature hybrid 22b operates as RF combiner connected to a balanced RF port of mixer 20', which also receives the unbalanced LO signal injected in-phase at a LO port. Two analog DC polarization blocks 23 and 24 individually controlled by a Mixer Control block 25 are connected to respective biasing inputs of mixer 20'. The IF input signal is frequency converted by the IRM block into a single-sideband RF signal which undergoes a first amplification by a RF pre-amplifier 26. The latter is cascaded by an RF interstage bandpass filter 28 and a variable-gain transmission power amplifier 29. Bandpass filter 28 is not mandatory and when is used has relaxed out of band characteristic. The TX power amplifier 29 is coupled to a RF power splitter 30 which splits the RF signal towards a diplexer filter 31 and a detection and control loop including a power detector and mixer diode 40 and an ALC block connected to the gain control input of the RF power amplifier 29. The spurious emission limits are always guaranteed by diplexer filter 31.

The biasing calibration feedback loop includes the cascade of the following blocks: the mixer 40, an IF bandpass filter 35, a Log-detector amplifier 41, an A/D converter 38, the Mixer Control block 25, two D/A converters 42, 43, and the biasing blocks 23, 24. Component 40 is a diode pumped by the RF power so as to down-convert to IF at the output of the bandpass filter 35 (the $IF_{BACK}$ spectral line visible in the lowest ellipse) the residual of LO ($LO_{RES}$ spectral line visible in the uppermost ellipse). The element 41 is a logarithmic amplifier operating as envelope detector of the down-converted IF power. A logarithmic amplifier is needed because of the large dynamic of the IF envelope due to dependence on the RTCP functionality. The output of the Log-detector amplifier 41 is a DC signal $V_{REG}$ directed to the A/D converter 38 at the input of the microcontroller 25. The latter calculates two digital values Vd1 and Vd2 useful to update the diode mixer polarizations and forwards them to respective D/A converters 42, 43. The analog Vd1, Vd2 voltages are input to DC blocks 23 and 24, respectively to be converted into biasing current Id1 and Id2, respectively.

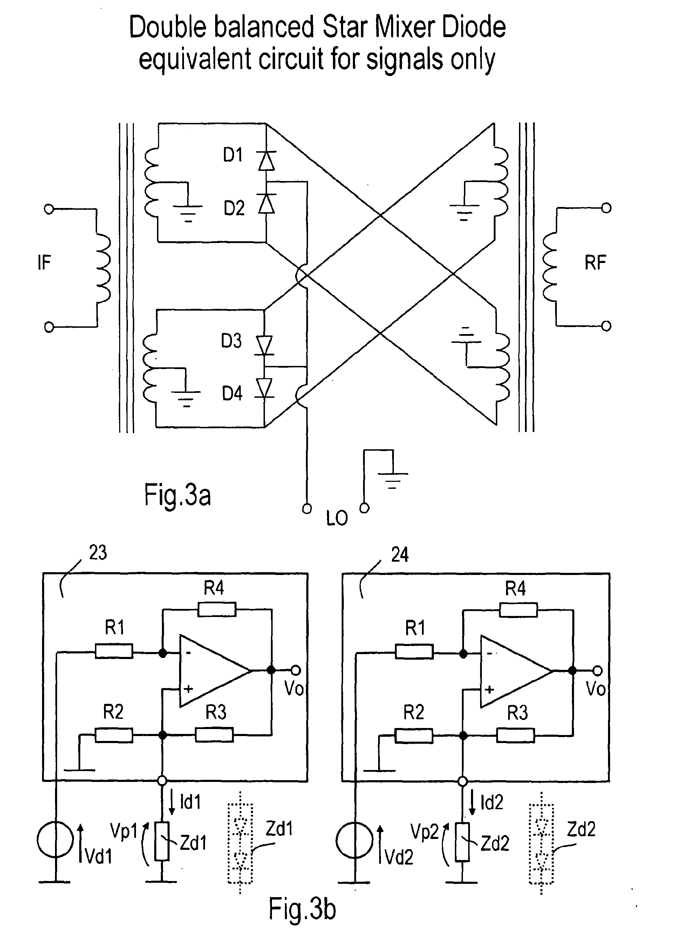

An equivalent circuit of a double-balanced mixer (corresponding to the block 20' inside the IRM 20) valid for the only signals excluded polarization is visible in **fig.3a;** the circuit includes two pairs of serially connected diodes D1, D2 and D3, D4. The two pairs of diodes are connected in counterphase and are fed at the centre of the two diodes with unbalanced LO signal. The RF and IF ports are both balanced with respect to ground. **Fig.3b** shows the circuital realization of the DC biasing blocks 23 and 24. With reference to **fig.3b,** the two identical blocks 23 and 24 include an operational amplifier in voltage-to-current converter configuration with the load connected to ground. Block 23 includes four resistors R1, R2, R3, and R4, of which: R3 and R4 are connected between the output Vo and the inputs + and -, respectively; R2 is connected between the input + and ground; R1 is connected to the output of D/A 43 and the input - of the operational in order to input the biasing voltage Vd1. The input + is further connected to a load Zd1 connected to ground, which corresponds to the resistance of a first pair of diodes included in the mixer 20'. Thanks to the given configuration and assuming the ratio R4/R1 = R3/R2, a biasing current Id1 = -Vd1/R2 independent of Zd1 flows through the load Zd1 and hence through the diodes. A biasing voltage Vp1 = Id1xZd1 is set across the load Zd1. The same conclusions are valid for DC block 24, respectively for Vd2, Id2, Zd2, and Vp2.

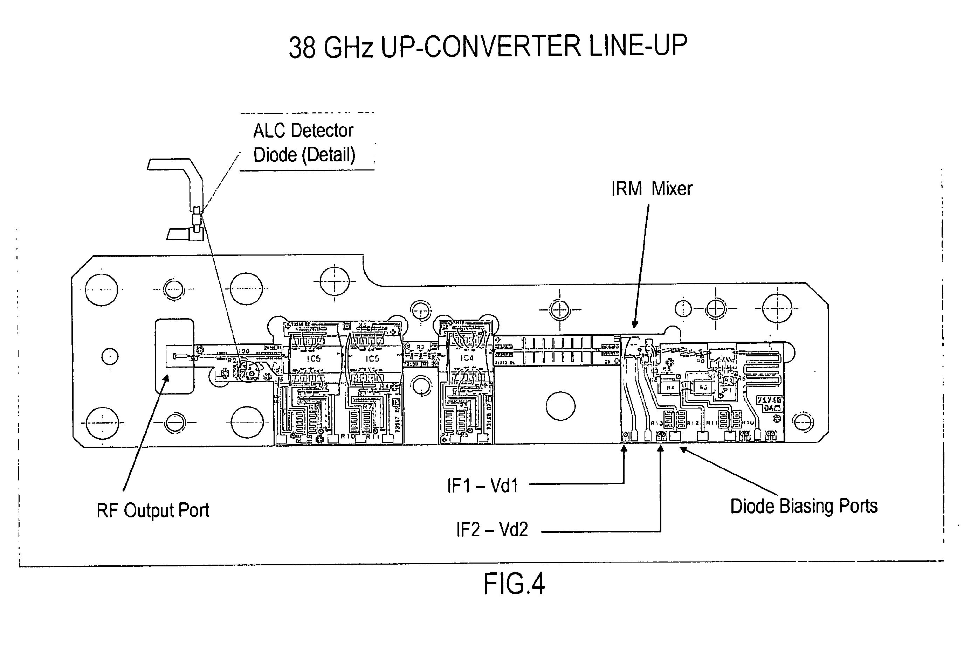

The real thin film implementation of a 38 GHz up-converter on alumina substrate is illustrated in **fig.4.**

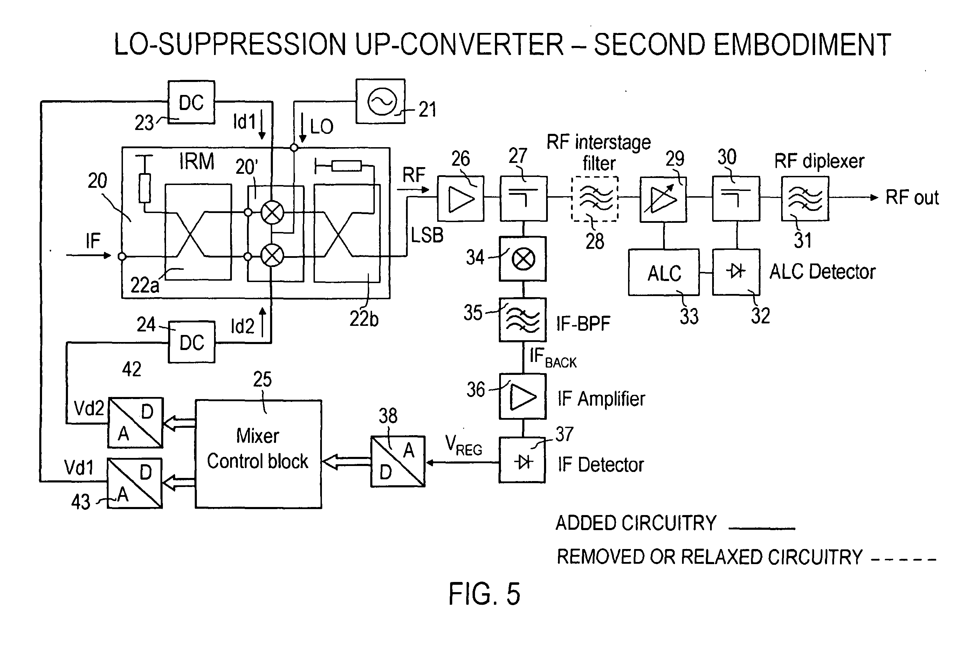

**Fig.5** shows an alternative embodiment of the circuitry for the suppression of residual LO, where the same elements as in **fig.2** are indicated by the same symbols. With reference to **fig.5,** we see that the circuitry represented in the left part of the figure and including the devices: 38, 25, 42, 43, 23, 24, 20, and 26 is the same as the corresponding part of **fig.2.** A splitter 27 splits the RF signal at the output of the pre-amplifier 26 into two signals and forwards a first one to an ALC control part and a second one to a feedback biasing calibration loop.

The ALC loop is separated from the splitter 27 by an RF interstage bandpass filter 28 that is not mandatory and, if present, has relaxed out of band characteristic. The ALC loop includes a variable gain RF power amplifier 29 coupled to a power splitter 30 which splits the RF signal towards a diplexer filter 31 and a detection and control loop including a power detector diode 32 and an ALC block connected to the gain control input of the RX power amplifier 29. The spurious emission limits are always guaranteed by diplexer filter 31.

The biasing calibration feedback loop includes the cascade of the following blocks: a mixer 34 pumped by the RF signal, an IF bandpass filter 35, an IF amplifier 36, an IF detector 37, and blocks 38, 25, 42, 43, 23 and 24. As previously said, at the output of mixer 34 an $IF_{BACK}$ intermediate frequency power which follows the residual power of LO is obtained. This $IF_{BACK}$ power is originated from the beating between residual LO from the system IF up-conversion and the RF signal as driving power. The output of the IF detector 37 is a DC signal $V_{REG}$ directed to the A/D converter 38 at the input of the microcontroller 25. The latter calculates two digital values Vd1 and Vd2 for updating two bias voltages of block IRM 20, separately, and forwards them to the respective D/A converters 42, 43.

In operation, in order to optimize the symmetry of the mixer diodes and achieve good LO/RF isolation, the DC bias voltages of mixer diodes are separately adjusted. To describe the autocalibration technique, an experimental 38 GHz up-converter supporting 128 QAM modulated signal is used. In this case the IF input signal is -5 dBm at 350 MHz, the LO signal is +15 dBm at 38.35 GHz, the RF converted signal is 15 dBm at 38 GHz (Lower Side Band) and the LO signal leakage at output $LO_{res}$ is -15 dBm at 38 GHz, that is 30 dBc below the usefull RF signal. Our goal is to obtain 50 dBc below.

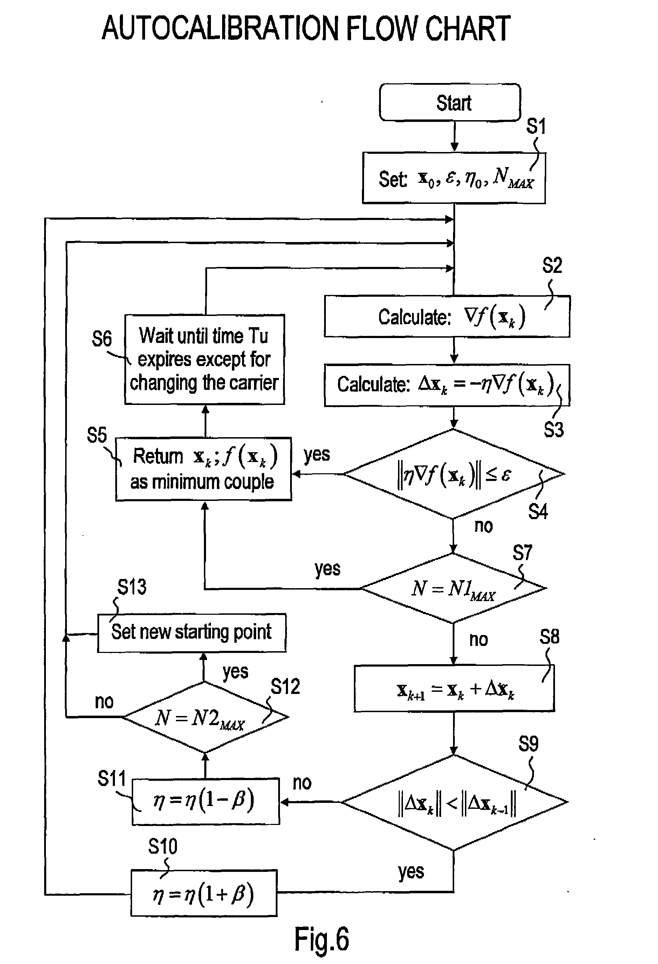

The biasing calibration method is nearly the same for the two embodiments of the invention, so that the only one of **fig.2** is discussed. As said before, the ALC detector 40 acts as a down-converter mixer too, anyway in this case the pump signal is the RF signal and the $O_{RES}$ is the input signal. The downconverted signal is the regenerated IF signal $IF_{BACK}$ at 350 MHz with a power level of -50 dBm. This signal is linear related to the $LO_{RES}$ signal; if $LO_{RES}$ 1 dB decreases, $IF_{BACK}$ 1 dB dcreases too. The log-detector 41, which is fed by the $IF_{BACK}$ signal, generates a DC signal $V_{REG}$ that is used by the microcontroller 25 to adjust the biasing of mixer diodes to improve LO signal output suppression. The log-detector is used in order to have a wide dynamic range and a high detection sensitivity. The microcontroller routine works according the following steps shown in **fig.6.**

With reference to **fig.6,** the microcontroller 25 in standby status S1 is switched on in step S2 to start the $LO_{RES}$ minimization routine based on the well known gradient method or one of its many variants, e.g.: steepest descent, conjugate gradient, etc. The aim of the method is to find a local minimum of a function $f(\mathbf{x})$ iteratively, starting from an initial point $x_0$ and terminating only when the absolute gradient value falls below an $\varepsilon$ value as small as whished. The argument of the object function $f(\mathbf{x})$ is a n-dimensional vector $\mathbf{x}$. In the concrete case, the function f is $V_{REG}(Id1, Id2)$; $\mathbf{x}$ is a vector $[Id1, Id2]^T$, and $\mathbf{x}_0 = [Id1_0, Id2_0]^T$ is a vector representing the initial working points of the diode pairs 20' as reported in the component data sheets. The function $V_{REG}(Id1, Id2)$ is achievable in known way from the following items:

- I(V) exponential characteristics of diodes used to set the working point of the double-balanced mixer;
- physical model used to describe their radiofrequency behaviour of diodes;
- power of the LO pump signal;
- phase relations and frequency behaviour at the various ports of hybrids used by the single-sideband frequency converter;
- gain of the various chained blocks;
- bandpass response of the interstage filter;
- conductance of the voltage-to-current converters.

Instead of deriving the function $V_{REG}(Id1, Id2)$ by means of pure theoretical considerations, which is very difficult task, it can be experimentally derived interpolating through a grid of measures involving couple of bias currents and corresponding values of $V_{REG}$. Several surface interpolating method using different form of interpolating functions are known in the literature, e.g. bilinear, bicubic polynomial functions. The descent gradient method includes the following steps:

1. (Step S1) - Set the initial polarization currents $Id1_0$, $Id2_0$ of diode pairs 20'. In order to better agree with iterative handling we pose: $Id1_k$, $Id2_k$ (initial k = 0). Set the stop value $\varepsilon$ and the initial learning factor $\eta_0$. The stop value $\varepsilon$ shall be selected in a way that $LO_{RES}$ power reaches a target $\leq$ -50 dBc. The goal, conceptually achievable, corresponds to a good symmetry on the behaviour of the upconverter, but this doesn't necessarily means perfect equality of the two bias currents.

2. (Step S2) - Calculate $\nabla V_{REG}(Id1_k, Id2_k)$, (V is the gradient operator) in point $\mathbf{x}_k = [Id1_k, Id2_k]$ :

$$\nabla V_{REG}\left(Id1_k, Id2_k\right) = \left[ \left. \frac{\partial V_{REG}\left(Id1, Id2\right)}{\partial Id1} \right|_{Id1=k}, \left. \frac{\partial V_{REG}\left(Id1_k, Id2_k\right)}{\partial Id2} \right|_{Id2=k} \right].$$

3. (Step S3) - Calculate the displacement $\Delta x_k$ from point $\mathbf{x}_k$ as:

$\Delta x_k = -\eta \nabla V_{REG}(Id1_k, Id2_k)$, where $\eta > 0$ is the learning factor, assumed to be very small so that the following inequality comes true: $V_{REG}(Id1_{k+1}, Id2_{k+1}) \leq V_{REG}(Id1_k, Id2_k)$. This means moving in the opposite direction in respect of the gradient.

4. (Step S4) - If $\|\eta \nabla V_{REG}(Id1_k, Id2_k)\| \leq \varepsilon$, it results that $\mathbf{x}_k = [Id1_k, Id2_k]$ is a point of local minimum of the function $V_{REG}(Idl_k, Id2_k)$; as a consequence the cycle is temporarily stopped.

5. (Step S5) - The couple $x_k$; $f(x_k)$ is returned as minimum couple.

6. (Step S6) - A waiting time interval Tu is entered before a new minimization cycle is restarted (Step S2). Time Tu is in the order of few seconds to match with physical phenomena having effect on mixer unbalance, e.g. temperature and aging, are slow. Nevertheless in case the carrier is changed before time Tu is elapsed, the wait is interrupted and a new updating iteration introduced (Step S2). Whether the condition on $\varepsilon$ is false the algorithm continues with the next updating step S7.

7. (Step S7) - Before calculating a new point, the current iteration number is compared to the maximum permissible number of iterations $N1_{MAX}$ to reach the convergence; in case of equality the actual $\mathbf{x}_k$; $f(\mathbf{x}_k)$ is returned as minimum couple.

8. (Step S8) - Calculate a new point $\mathbf{x}_{k+1} = x_k + \Delta x_k$, that is:

$$Id1_{k+1}, Id2_{k+1} = Id1_k, Id2_k - \eta \nabla V_{REG} \left( Id1_k, Id2_k \right).$$

9. (Step S9) - The condition: $\|\nabla V_{REG}(Id1_k, Id2_k)\| < \|\nabla \Delta_{REG}(Id1_{k+1}, Id2_{k-1})\|$ is tested as a criterion to update the learning factor $\eta$ in order to accelerate the convergence of the method (e.g. using Vogl's algorithm).

10. (Step S10) - If the condition checked in Step S9 is true the learning factor $\eta$ is increased of a certain percentage $\beta$ as greater as the difference between iterations $k$ and $k$-1 of the module of gradient increases, and a new updating iteration is entered (Step S2).

11. (Step S11) - If the condition checked in Step S9 is false the learning factor $\eta$ is decreased of a certain percentage $\beta$ as greater as the difference between iterations $k$ and $k$-1 of the module of gradient increases.

12. (Step S12) - The current iteration number is compared to the maximum permissible number of iterations $N2_{MAX}$ waiting for gradient reduction. If number $N2_{MAX}$ is not reached a new updating iteration is entered (Step S2).

13. (Step S13) - If the number $N2_{MAX}$ is reached another starting point is selected and a new minimization cycle is entered (Step S2).

Although the invention has been described with particular reference to a preferred embodiment, it will be evident to those skilled in the art, that the present invention is not limited thereto, but further variations and modifications may be applied without departing from the scope thereof.

## Claims

1. Method to improve local oscillator LO signal rejection in single-sideband radiofrequency up-converters (20) comprising a balanced or double-balanced mixer (20') including diodes (D1, D2, D3, D4) biased with adjustable currents (Id1, Id2) to improve said rejection, the method including the steps of:

   a) driving an auxiliary mixer (34, 40) with the output radiofrequency RF signal for down-converting the residual power of LO signal from the beating between the two signals;
   b) detecting (35, 36, 41, 37) a down-converted residual power of LO signal to generate a quasi-continuous voltage $V_{REG}$
   c) obtaining (25, 42, 43, 23, 24) from said voltage $V_{REG}$ two voltages Vd1 and Vd2 to continuously updating the biasing currents Id1 and Id2 of said diodes,

   **characterized in that** in step c) said quasi-continuous voltage $V_{REG}$ is firstly expressed as a mathematical function $V_{REG}$(Id1, Id2), of the two bias currents Id1 and Id2 and then minimized through the gradient descent algorithm or through any other equivalent algorithms.

2. The method of claim 1, **characterized in that** step c) includes in its turn the steps of:

   d) calculating (25) the gradient of said mathematical function $V_{REG}(Id1_k, Id2_k)$ where index k indicates the actual calculation step;
   e) multiplying the gradient by a learning factor $\eta > 0$ and changing the sign of the product in order to find a vectorial variation of the bias currents for updating both $Id1_k$, $Id2_k$ and $V_{REG}(Id1_k, Id2_k)$;
   f) comparing the module of said product with a predetermined target threshold $\epsilon$ and if the module is lower than or equal to said threshold $\epsilon$ calculating next values of the bias currents $Id1_{k+1}$, $Id2_{k+1}$ by summing up said vectorial variation of the bias currents to the actual values $Id1_k$ and $Id2_k$ and, after a waiting time is expired and Vd1 and Vd2 updated, executing a new updating iteration from step d), otherwise when said module is equal to or lower than the threshold $\epsilon$ stopping to update the bias currents and executing a new updating iteration from step d) after the waiting time is expired and Vd1 and Vd2 updated.

3. The method of claim 1, **characterized in that** said function $V_{REG}$(Id1, Id2) is derived by pure theoretical considerations.

4. The method of claim 1, **characterized in that** said function $V_{REG}$(Id1, Id2) is experimentally derived interpolating through a grid of measures involving couple of bias currents $Id1_k$, $Id2_k$ and corresponding $V_{REG}$ values.

5. The method of claim 1, **characterized in that** said residual power of LO signal is down-converted to intermediate frequency IFat step a).

**6.** The method of claim 1; **characterized in that** the initial bias current values are set.

**7.** System to improve local oscillator LO signal rejection in single-sideband radiofrequency up-converter (20) comprising a balanced or double-balanced mixer (20') including diodes (D1, D2, D3, D4), the system including:

> • a radiofrequency RF power splitter (27, 30) connected downstream the up-converter (20) in order to derive an RF power towards an auxiliary mixer (34, 40);
> • detection means (36, 37, 41) cascaded to said auxiliary mixer (34, 40) for outputting a quasi-continuous voltage, $V_{REG}$, and which detection means receives the down-converted residual power of LO signal,
> • control means (25, 42, 43, 23, 24) configured for deriving from said voltage $V_{REG}$ two voltages Vd1 and Vd2 to continuously updating the biasing currents Id1 and Id2 of said diodes (D1, D2, D3, D4) ;

> **characterized in that** said control means include:

> • processor means (25) appositely programmed to express said voltage $V_{REG}$ as a mathematical function $V_{REG}$ (Id1, Id2) of said bias currents Id1 and Id2 and then minimizing it through the gradient descent algorithm or through any other equivalent minimization algorithms.
> • voltage-to-current conversion means (23, 24) placed downstream said processor means (25) for obtaining said bias currents Id1 and Id2.

**8.** The system of claim 7, **characterized in that** said auxiliary mixer (40) also constitutes the RF detector of an automatic level control loop (ALC) driven by the RF signal power at the output of a final power amplifier (29).

**9.** The up-converter of claim 8, **characterized in that** said detection means includes a logarithmic amplifier (41) outputting said quasi-continuous voltage $V_{REG}$.

**Patentansprüche**

**1.** Verfahren zur Verbesserung der Signalrückweisung von Empfängeroszillatoren LO in Einseitenband-Hochfrequenz-Aufwärtsmischern (20) mit einem symmetrischen oder Gegentaktmischer (20') mit Dioden (D1, D2, D3, D4), die mit einstellbaren Strömen (Id1, Id2) vorgespannt werden, um die Rückweisung zu verbessern, wobei das Verfahren die folgenden Schritte umfasst:

> a) Ansteuern eines Hilfsmischers (34, 40) mit dem Ausgangs-Hochfrequenz- bzw. HF-Signal zum Heruntermischen der Restleistung des LO-Signals aus der Schwebung zwischen den beiden Signalen;
> b) Detektieren (35, 36, 41, 37) einer heruntergemischten Restleistung des LO-Signals, um eine quasikontinuierliche Spannung $V_{REG}$ zu erzeugen,
> c) Erhalten (25, 42, 43, 23, 24) von zwei Spannungen Vd1 und Vd2 aus der Spannung $V_{REG}$, um die Vorströme Id1, Id2 der Dioden kontinuierlich zu aktualisieren,
> **dadurch gekennzeichnet, dass** im Schritt c) die quasikontinuierliche Spannung $V_{REG}$ zuerst als eine mathematische Funktion $V_{REG}$(Id1, Id2) der beiden Vorströme Id1, Id2 ausgedrückt und dann durch den Gradientenabstiegsalgorithmus oder durch beliebige andere äquivalente Algorithmen minimiert wird.

**2.** Verfahren nach Anspruch 1, **dadurch gekennzeichnet, dass** Schritt c) seinerseits die folgenden Schritte umfasst:

> d) Berechnen (25) des Gradienten der mathematischen Funktion $V_{REG}(Id1_k, Id2_k)$, wobei der Index k den tatsächlichen Berechnungsschritt angibt;
> e) Multiplizieren des Gradienten mit einem Lernfaktor $\eta > 0$ und Ändern des Vorzeichens des Produkts, um eine vektorielle Variation der Vorströme zur Aktualisierung sowohl von $Id1_k$, $Id2_k$ als auch von $V_{REG}(Id1_k, Id2_k)$ zu finden;
> f) Vergleichen des Modulus des Produkts mit einer vorbestimmten Zielschwelle $\varepsilon$, und wenn der Modulus kleiner oder gleich der Schwelle $\varepsilon$ ist, Berechnen von nächsten Werten der Vorströme $Id1_{k+1}$, $Id2_{k+1}$ durch Aufsummieren der vektoriellen Variation der Vorströme zu tatsächlichen Werten $Id1_k$, $Id2_k$ und, nachdem eine Wartezeit abgelaufen ist und Vd1 und Vd2 aktualisiert sind, Ausführen einer neuen Aktualisierungsiteration von Schritt d) an, andernfalls, wenn der Modulus kleiner oder gleich der Schwelle $\varepsilon$ ist, Aufhören mit dem Aktualisieren der Vorströme und Ausführen einer neuen Aktualisierungsiteration von Schritt d) an, nachdem die Wartezeit abgelaufen ist und Vd1 und Vd2 aktualisiert sind.

3. Verfahren nach Anspruch 1, **dadurch gekennzeichnet, dass** die Funktion $V_{REG}$(Id1, Id2) durch rein theoretische Betrachtungen abgeleitet wird.

4. Verfahren nach Anspruch 1, **dadurch gekennzeichnet, dass** die Funktion $V_{REG}$(Id1, Id2) experimentell abgeleitet wird, wobei durch ein Gitter von Maßen unter Beteiligung von Paaren von Werten der Vorströme $Id1_k$, $Id2_k$ und entsprechenden $V_{REG}$-Werten interpoliert wird.

5. Verfahren nach Anspruch 1, **dadurch gekennzeichnet, dass** die Restleistung des LO-Signals im Schritt a) auf Zwischenfrequenz ZF heruntergemischt wird.

6. Verfahren nach Anspruch 1, **dadurch gekennzeichnet, dass** die Anfangsvorstromwerte gesetzt werden.

7. System zur Verbesserung der Signalrückweisung von Empfängeroszillatoren LO in Einseitenband-Hochfrequenz-Aufwärtsmischern (20) mit einem symmetrischen oder Gegentaktmischer (20') mit Dioden (D1, D2, D3, D4), wobei das System Folgendes umfasst:

   • einen Hochfrequenz- bzw. HF-Leistungsteiler (27, 30), der signalabwärts des Aufwärtsmischers (20) geschaltet ist, um eine HF-Leistung in Richtung eines Hilfsmischers (34, 40) abzuleiten;
   • an den Hilfsmischer (34, 40) kaskadierte Detektionsmittel (36, 37, 41) zum Ausgeben einer quasikontinuierlichen Spannung $V_{REG}$, und wobei die Detektionsmittel die heruntergemischte Restleistung des LO-Signals empfangen;
   • Steuermittel (25, 42, 43, 23, 24), die dafür ausgelegt sind, aus der Spannung $V_{REG}$ zwei Spannungen Vd1 und Vd2 zum kontinuierlichen Aktualisieren der Vorströme Id1, Id2 der Dioden (D1, D2, D3, D4) abzuleiten;

   **dadurch gekennzeichnet, dass** die Steuermittel Folgendes umfassen:

   • Prozessormittel (25), die geeignet dafür programmiert sind, die Spannung $V_{REG}$ als mathematische Funktion $V_{REG}$(Id1, Id2) der beiden Vorströme Id1, Id2 auszudrücken und sie dann durch den Gradientenabstiegsalgorithmus oder durch beliebige andere äquivalente Algorithmen zu minimieren;
   • Umsetzungsmittel (23, 24) von Spannung in Strom, die signalabwärts der Prozessormittel (25) platziert werden, um die Vorströme Id1, Id2 zu erhalten.

8. System nach Anspruch 7, **dadurch gekennzeichnet, dass** der Hilfsmischer (40) auch den HF-Detektor einer automatischen Pegelregelschleife (ALC) bildet, die durch die HF-Signalleistung an dem Ausgang eines Leistungs-Endverstärkers (29) angesteuert wird.

9. Aufwärtsmischer nach Anspruch 8, **dadurch gekennzeichnet, dass** die Detektionsmittel einen logarithmischen Verstärker (41) umfassen, der die quasikontinuierliche Spannung $V_{REG}$ ausgibt.


**Revendications**

1. Procédé pour améliorer un rejet de signal LO d'oscillateur local dans des convertisseurs à la hausse de radiofréquences de bande latérale unique (20) comprenant un mélangeur équilibré ou double équilibré (20') incluant des diodes (D1, D2, D3, D4) polarisées avec des courants ajustables (Id1, Id2) pour améliorer ledit rejet, le procédé incluant les étapes de :

   a) excitation d'un mélangeur auxiliaire (34, 40) avec le signal de radiofréquence RF de sortie pour convertir à la baisse la puissance résiduelle de signal LO à partir du battement entre les deux signaux ;
   b) détection (35, 36, 41, 37) d'une puissance résiduelle de signal LO convertie à la baisse pour générer une tension quasi continue $V_{REG}$ ;
   c) obtention (25, 42, 43, 23, 24) à partir de ladite tension $V_{REG}$ de deux tensions Vd1 et Vd2 pour mettre à jour de façon continue les courants de polarisation Id1 et Id2 desdites diodes,

   **caractérisé en ce qu'**à l'étape c), ladite tension quasi continue $V_{REG}$ est d'abord exprimée comme une fonction mathématique $V_{REG}$(Id1, Id2) des deux courants de polarisation Id1 et Id2 et ensuite minimisée par l'algorithme de descente de gradient ou par un quelconque autre algorithme équivalent.

**2.** Procédé selon la revendication 1, **caractérisé en ce que** l'étape c) inclut elle-même les étapes de :

d) calcul (26) du gradient de ladite fonction mathématique $V_{REG}$ ( $Id1_k$, $Id2_k$) où l'indice k indique l'étape de calcul actuelle ;

e) multiplication du gradient par un facteur d'apprentissage $\eta > 0$ et changement du signe du produit afin de trouver une variation vectorielle des courants de polarisation pour mettre à jour à la fois $Id1_k$, $Id2_k$ et $V_{REG}$ ( Id1k, $Id2_k$) ;

f) comparaison du module dudit produit avec un seuil cible prédéterminés $\varepsilon$ et si le module est inférieur ou égal audit seuil $\varepsilon$, calcul des valeurs suivantes des courants de polarisation $Id1_{k+1}$, $Id2_{k+1}$ en ajoutant ladite variation vectorielle des courants de polarisation aux valeurs actuelles $Id1_k$ et $Id2_k$ et, après expiration d'un délai d'attente et mise à jour de Vd1 et Vd2, exécution d'une nouvelle itération de mise à jour à partir de l'étape d), sinon lorsque ledit module est égal ou inférieur au seuil $\varepsilon$, arrêt de la mise à jour des courants de polarisation et exécution d'une nouvelle itération de mise à jour à partir de l'étape d) après expiration du délai d'attente et mise à jour de Vd1 et Vd2.

**3.** Procédé selon la revendication 1, **caractérisé en ce que** ladite fonction $V_{REG}$(Id1, Id2) est dérivée par de pures considérations théoriques.

**4.** Procédé selon la revendication 1, **caractérisé en ce que** ladite fonction $V_{REG}$(Id1, Id2) est dérivée expérimentalement par interpolation par une grille de mesures impliquant un couple de courants de polarisation $Id1_k$, $Id2_k$ et des valeurs $V_{REG}$ correspondantes.

**5.** Procédé selon la revendication 1, **caractérisé en ce que** ladite puissance résiduelle de signal LO est convertie à la baisse à une fréquence IF intermédiaire à l'étape a).

**6.** Procédé selon la revendication 1, **caractérisé en ce que** les valeurs initiales de courants de polarisation sont fixées.

**7.** Système pour améliorer un rejet de signal LO d'oscillateur local dans un convertisseur à la hausse de radiofréquences de bande latérale unique (20) comprenant un mélangeur équilibré ou double équilibré (20') incluant des diodes (D1, D2, D3, D4), le système incluant :

• un diviseur de puissance de radiofréquence RF (27, 30) connecté en aval du convertisseur à la hausse (20) afin de dériver une puissance RF vers un mélangeur auxiliaire (34, 40) ;

• un moyen de détection (36, 37, 41) en cascade avec ledit mélangeur auxiliaire (34, 40) pour délivrer en sortie une tension quasi continue, $V_{REG}$, et lequel moyen de détection reçoit la puissance résiduelle de signal LO convertie à la baisse ;

• un moyen de commande (25, 42, 43, 23, 24) configuré pour dériver de ladite tension $V_{REG}$ deux tensions Vd1 et Vd2 pour mettre à jour de façon continue les courants de polarisation Id1 et Id2 desdites diodes (D1, D2, D3, D4) ;

**caractérisé en ce que** ledit moyen de commande inclut :

• un moyen de processeur (25) programmé de façon appropriée pour exprimer ladite tension $V_{REG}$ comme une fonction mathématique $V_{REG}$(Id1, Id2) desdites courants de polarisation Id1 et Id2 et ensuite la minimiser par l'algorithme de descente de gradient ou par un quelconque autre algorithme de minimisation équivalent;

• un moyen de conversion de tension en courant (23, 24) placé en aval dudit moyen de processeur (25) pour obtenir lesdits courants de polarisation Id1 et Id2.

**8.** Système selon la revendication 7, **caractérisé en ce que** ledit mélangeur auxiliaire (40) constitue également le détecteur RF d'une boucle de commande de niveau automatique (ALC) excitée par la puissance de signal RF à la sortie d'un amplificateur de puissance final (29).

**9.** Système selon la revendication 8, **caractérisé en ce que** ledit moyen de détection inclut un amplificateur logarithmique (41) délivrant en sortie ladite tension quasi continue $V_{REG}$.

# LO-SUPPRESSION UP-CONVERTER OF THE KNOWN ART

FIG. 1

EP 1 841 058 B1

# LO-SUPPRESSION UP-CONVERTER – FIRST EMBODIMENT

FIG. 2

ADDED CIRCUITRY _____

REMOVED OR RELAXED CIRCUITRY - - - - -

EP 1 841 058 B1

# Double balanced Star Mixer Diode
## equivalent circuit for signals only

Fig.3a

Fig.3b

# 38 GHz UP-CONVERTER LINE-UP

ALC Detector
Diode (Detail)

IRM Mixer

RF Output Port

IF1 – Vd1

IF2 – Vd2

Diode Biasing Ports

## FIG.4

EP 1 841 058 B1

# LO-SUPPRESSION UP-CONVERTER – SECOND EMBODIMENT

FIG. 5

ADDED CIRCUITRY _____

REMOVED OR RELAXED CIRCUITRY - - - - -

EP 1 841 058 B1

# AUTOCALIBRATION FLOW CHART

**Start**

S1 — Set: $\mathbf{x}_0, \varepsilon, \eta_0, N_{MAX}$

S2 — Calculate: $\nabla f(\mathbf{x}_k)$

S3 — Calculate: $\Delta \mathbf{x}_k = -\eta \nabla f(\mathbf{x}_k)$

S4 — $\|\eta \nabla f(\mathbf{x}_k)\| \le \varepsilon$ — yes

S6 — Wait until time Tu expires except for changing the carrier

S5 — Return $\mathbf{x}_k ; f(\mathbf{x}_k)$ as minimum couple

S7 — $N = N1_{MAX}$ — yes / no

S8 — $\mathbf{x}_{k+1} = \mathbf{x}_k + \Delta \mathbf{x}_k$

S9 — $\|\Delta \mathbf{x}_k\| < \|\Delta \mathbf{x}_{k-1}\|$ — no / yes

S13 — Set new starting point

S12 — $N = N2_{MAX}$ — yes / no

S11 — $\eta = \eta(1 - \beta)$

S10 — $\eta = \eta(1 + \beta)$

## Fig.6

**EP 1 841 058 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5162763 A, Morris

**Non-patent literature cited in the description**

- **W. Schiller ; Nuernberg, D.** Broadband linear SSB-upconverter with electronically-controlled LO-suppression for 16 QAM applications at 4 GHz. *Conf. Proc. 13th European Microwave Conf.,* 05 September 1983

- **Watkins-Johnson.** *Company - Tech-Notes,* May 1985, vol. 12 (3
- **Halford, B. R.** Single-Sideband Mixers for Communication Systems. *IEEE MTT Symposiums Digest,* 1982, 30-32